# EUROPEAN PATENT APPLICATION

(11) **EP 4 431 795 A1**
(43) Date of publication of application: **18.09.2024**
(21) Application number: 23161720.0
(22) Date of filing: 14.03.2023
(51) Int. Cl.: F21S 41/19, F21S 41/148, F21S 41/39, F21S 43/19, F21S 43/14, F21S 43/37, F21S 45/00, H01R 12/71, H05K 1/11

(54) **AUTOMOTIVE LUMINOUS DEVICE INCLUDING FIXING MEANS TO CONNECT A CONNECTOR TO A SUBSTRATE**

(71) Applicant: Valeo Vision, 93012 Bobigny Cedex (FR)
(72) Inventor: CANTUDO FRANCO, Miguel Angel, 23600 MARTOS (ES); ROLDAN ZAFRA, Jose David, 23600 MARTOS (ES)
(74) Representative: Valeo Visibility

(57) **Abstract**

The invention provides an automotive luminous device (10) comprising a main support (3), an electric connector (5) and a substrate (1). The main support (3) comprises first fixing means. The electric connector (5) is attached to the main support (3) and comprises electric connector terminals (6). The substrate (1) comprises substrate pads (4) configured to cooperate with the electric connector terminals (6), and further comprising an electronic component (2) electrically connected to at least one of the substrate pads (4). The luminous device further comprises second fixing means (7) configured to cooperate with the first fixing means to keep the rigid plane substrate in a connecting position where the substrate pads (4) are in contact with the electric connector terminals (6).

## Description

### TECHNICAL FIELD

This invention belongs to the field of the arrangements of the elements of an automotive luminous device.

### STATE OF THE ART

Automotive lighting market can be considered one of the most competitive ones and new lighting functions are constantly required.

Current automotive designs for lighting devices require more functionalities in a reduced space. This creates new challenges for the manufacturer, who must deal with entanglements and assembly issues: to be able to create electric connections in a reduced space, an extra length must be provided to the harness. This extra length must be then encapsulated in a more reduced space, thus creating a wide range of problems.

Further, the competitors' solutions also press the manufacturer to optimize manufacturing time and cost.

The present invention provides a solution for connecting different elements inside an automotive lighting device, reducing space and cost.

### DESCRIPTION OF THE INVENTION

The present invention provides a solution for these problems by means of an automotive luminous device comprising:
- a main support comprising first fixing means;
- an electric connector attached to the main support, the electric connector comprising electric connector terminals;
- a substrate comprising substrate pads configured to cooperate with the electric connector terminals and further comprising an electronic component electrically connected to at least one of the substrate pads.

According to the invention, the luminous device further comprises second fixing means configured to cooperate with the first fixing means to keep the substrate in a connecting position where the substrate pads are in contact with the electric connector terminals.

The electric connector terminals are electric terminals which are comprised in the connector. These terminals are conductive elements which are configured to transmit electric signals from an external power supply. The shape of these terminals is not restricted by any particular design, as far as they are configured to be contacted by the corresponding pads.

The electric pads are electric terminals which offer a plane side to contact the corresponding electric terminals of the connector. The pads are in contact with the electric connector terminals. This means that the pads are in electric contact with the electric connector terminals.

With this arrangement, the substrate pads of the substrate are in contact with the electric connector terminals thanks to the cooperation between the first and second fixing means Thus, the electric contact between the connector and the rigid substrate is achieved without the need of an additional connection means to hold the connector attached to the substrate. This saves space, time and cost and is advantageous for the manufacturing of the device, since the arrangement of the rigid substrate on the connector can be automatized.

In some particular embodiments, the second fixing means are integrated in the substrate. This means that the second fixing means, which are mechanical elements which cooperate with the first fixing means, are an integral part of the substrate; i.e., a portion of the substrate has a suitable shape to cooperate with the first fixing means, thus achieving the aimed position for the substrate. Therefore, there is no need to provide additional parts: with the moulding process of the substrate is enough to create these elements.

In some particular embodiments, the first fixing means and the second fixing means are configured to form a snap-fit joint.

A snap-fit joint, which may be designed in the connector or in the main support, is also a good option for fixing the rigid substrate to the main support and avoiding separation between them.

In some particular embodiments, the substrate is configured to receive the second fixing means. To do so, the substrate has housings or holes or through holes to receive an element which cooperates with the first fixing means. There are different mechanical solutions which fulfils the requirement of cooperating with further fixing means to keep the substrate in position with respect to the main support.

In some particular embodiments,
the second fixing means comprises a screw;
the first fixing means comprises a threaded element for the screw; and
the substrate has a through hole configured to be crossed by the screw so that the screw is engaged in the threaded element after passing through the through hole.

A screw is adequate, because it prevents the rigid substrate from moving in the vertical direction (the direction of the insertion of the screw) and also in a plane perpendicular to the insertion direction. Further, if the torque is enough, the screw is also useful to prevent rotation of the connector, so that the substrate pads do not deviate from the corresponding electric connector terminals. This effect of avoiding rotation can also be achieved by the guide elements, if they are present.

In some particular embodiments, the second fixing means are configured to cooperate with the first fixing means to press the rigid plane substrate against the electric connector. Pressure is an effective way of achieving the goal of electric contact.

In some particular embodiments, the substrate is a rigid plane substrate.

A rigid substrate should be understood in the sense of what the skilled person would construe. A skilled person knows the difference between a rigid substrate and a flexible substrate. Although every material is "flexible" in the sense that it has a stress-strain curve, a substrate which does not deform by its own weight when held by one of its ends is deemed to be rigid, while a substrate which suffer a substantial deformation when held by one of its ends is considered to be flexible. In any case, board manufacturers offer a "flexible" model and a "rigid" model, while any skilled person knows the difference between them.

In some particular embodiments, the electric connector is attached in a fixed manner to the main support.

Although in some cases the electric connector may be an integral part with the main support, it is an advantageous option to be manufactured as a separate part and then attached in a fixed manner to the main support, together with the harness. With this approach, manufacturing process is improved with more flexibility.

In some particular embodiments, the main support comprises third fixing means and the electric connector comprises fourth fixing means configured to cooperate with the third fixing means to attach the electric connector to the main support.

In these embodiments, the main support has at a same time the first fixing means intended to secure the substrate to the electric connector and the third fixing means intended to attach the electric connector to the main support. In other words, the first fixing means and the third fixing means are different, each of them having its own function. The same remark is applied to the second fixing means and the fourth fixing means, which are different from each other. In that respect, the proposed luminous device provides two separate means on one hand to fasten the electric connector to the main support and in the other hand to connect the substrate pads to the electric connector terminals. This helps to improve the solidity of the fixings in the module.

In some particular embodiments, the third fixing means comprises a guiding groove and the fourth fixing means comprises a guiding rib configured to engage in the guiding groove along an inserting direction.

This guiding grove is intended to guide the insertion of the electric connector when the electric connector is intended to be attached to the main support. This guiding grove provides an easy and single path to the electric connector, so that the electric connector is placed in a favourable location for an ulterior reception of the substrate pads.

In some particular embodiments, the main support and the electric connector comprises additional fastening means configured to retain the electric connector with respect to the main support in the inserting direction. For example, the additional fastening means can be a snap-fit connection.

In some particular embodiments, the additional fastening means comprises an elastic tab with an aperture and a snap-fit protrusion intended to engage in the aperture of the elastic tab.

This reinforces the attachment of the electric connector to the main support for some cases where it is needed (e.g., when the friction between the guides is not enough, when there are no more parts that prevent the connector from disengaging or for those cases where the requirements of the manufacturer advise this solution).

In some particular embodiments, the substrate may comprise printed circuits to connect electrically to the electronic component(s), the substrate being otherwise called printed circuit board (PCB).

In some particular embodiments, the electronic component is a solid-state light source.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

These light sources are specifically advantageous, since they provide the required luminous properties for the automotive regulations with a high efficiency and reliability.

In some particular embodiments, the main support is a housing, an optical element, or a bezel.

The connector may be installed in any of these elements, which can be found in standard automotive lighting devices.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements which are useful for transforming the light beams emitted by the light source into an acceptable light pattern for the functionality chosen for the lighting device.

In some particular embodiments, the electronic component is a driver element.

This invention can also be applied to the case where the electronic component is a driver element, since the advantageous feature is related to achieving an electric connection between two elements without providing any further connecting portion in the substrate. The substrate with the driver element may be arranged on a generic support of the luminous device (a housing, a bezel, etc).

In the above given example, the automotive luminous device further comprises a solid-state light source and an optical element arranged to receive the light emitted by the solid-state light source and project the light in a projection direction. The optical element can be a reflector, a lens or a light guide. The optical element can be arranged to receive the light emitted by the solid-state light source and project the light in a projection direction.

When the main support is an optical element which is used to project the light emitted by the solid-state light source, the substrate can be positioned with respect to this optical element, thus improving the optical performance of the device.

In some particular embodiments, the automotive luminous device comprises positioning means for positioning the substrate with respect to the main support.

In some particular embodiments, the positioning means comprise:
- first guide elements integrated in the main support or in the electric connector; and
- second guide elements integrated in the substrate configured to cooperate with the first guide elements to restraint the movement of the substrate with respect to the main support in at least one direction.

The guide elements help the substrate to be positioned in the correct position. These guide elements are not intended to press the substrate against the connector, but just to correct slight positioning errors in the plane of the substrate.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a first perspective view of the automotive luminous device according to figure 1, the automotive luminous device being in an explode mode.
Figure 2 shows a second perspective view of the automotive luminous device according to figure 1, but in an assembled mode.
Figure 3 shows a third perspective view of some elements of the automotive luminous device according to figure 1.
Figure 4 shows a fourth perspective view of some elements of the automotive luminous device according to figure 1, the fourth perspective view showing the luminous device from behind.
Figure 5 shows a fifth perspective view of the same elements as in figure 4 with different angle showing a bottom view of these elements and from behind.
Figure 6 shows a sectioned view of the automotive luminous device according to figure 1 taken along the line V-V illustrated in figure 4.

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

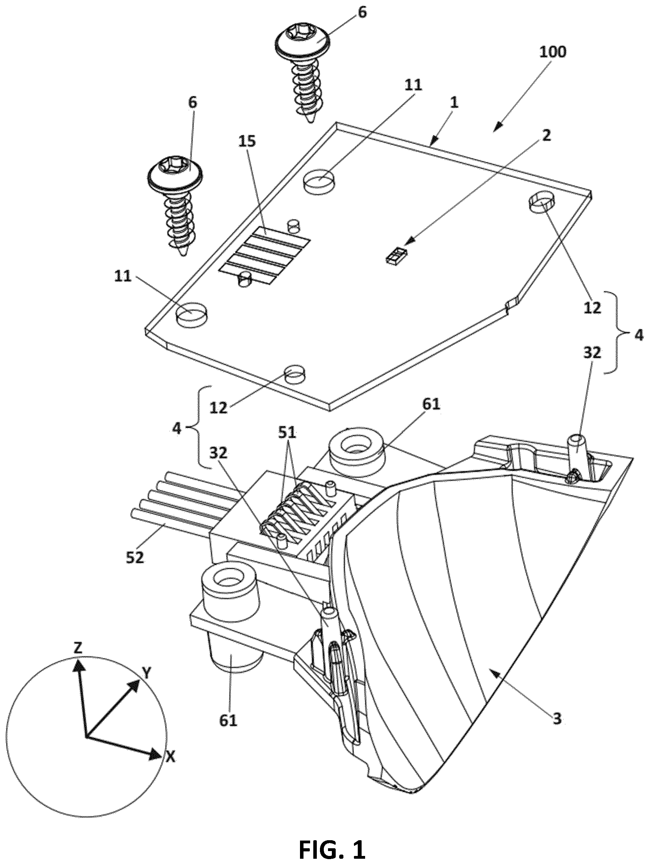

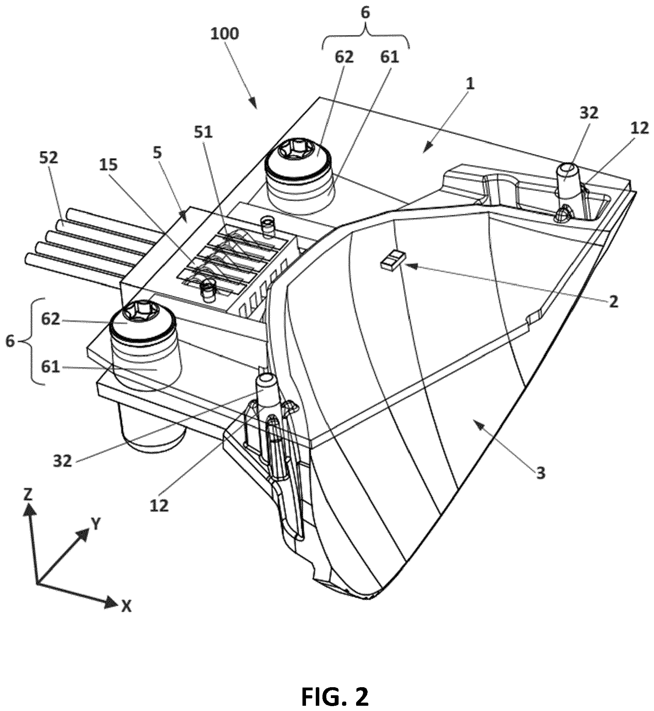

Figures 1 and 2 show a first perspective view of an automotive lighting device 100 according to an embodiment of the invention. Figure 1 shows an exploded view of the device 100, while figure 2 shows an assembled view of the same.

In these figures, there is a substrate, which in this case is a rigid planar substrate, such as a printed circuit board 1. This printed circuit board 1 comprises a solid-state light source, which in this case is a LED 2. This LED 2 is installed in the printed circuit board 1 and is intended to receive electric supply from substrate pads or electric pads 15, which are arranged in an edge of the printed circuit board 1.

For the sake of clarity, the printed circuit board 1 in Figures 1 and 2 is shown in a transparent mode in order to show elements located below the printed circuit board. In practice, the PCB may be composed of opaque layers.

The lighting device further comprises a main support, which in this case is a reflector 3. This reflector 3 is intended to receive the light emitted by the LED 2 and to project it in a projection direction when the luminous device is mounted on a vehicle. In the given example, the projection direction is along to the direction of the axis X shown in figure 1. Two other directions Y and Z are defined such as the lateral direction Y and the vertical direction Z form a Y-Z plane substantially perpendicular to the projection direction X.

The device further comprises a connector 5 fixed to the reflector 3 and intended to supply the power to the printed circuit board 1 via the electric pads. Details of the connection between the connector 5 and the reflector 3 will be described in further figures.

The connection between the printed circuit board 1 and the reflector 3 is advantageous in this embodiment, since with a single movement, the position of the LED 2 with respect to the reflector 3 and the electric connection between the printed circuit board 1 and the electric connector 5 are achieved.

In this case, these two simultaneous connections are achieved by means of the cooperation between the first fixing means 61 and the second fixing means 62, which form together a first set of fixing means 6, with the purpose of maintaining the printed circuit board 1 and the electric connector 5 in a connecting position as shown in figure 1 where the electric pads 15 are in contact with the electric connector terminals 51.

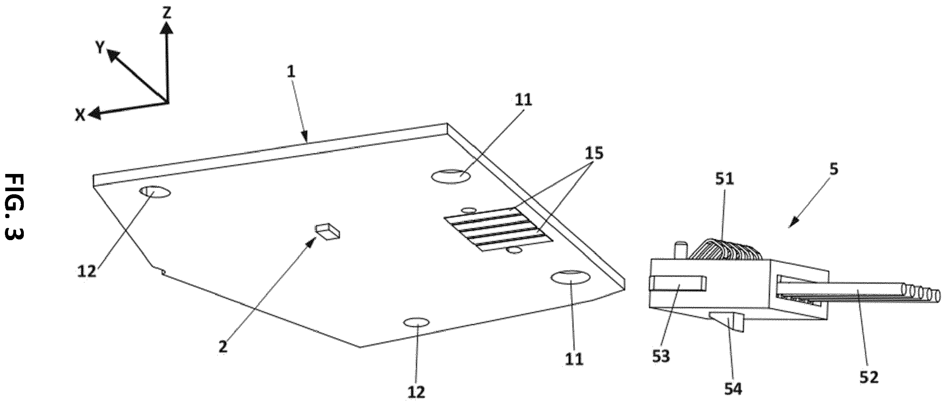

In the given example and as shown in figure 1 and in figure 3, the first fixing means comprise a shaft 61 with internal thread, otherwise called threaded shaft 61. The threaded shaft 61 is oriented vertically. Here there are two threaded shafts 61 arranged on either side of the connector 5. The two threaded shafts 61 are integrated into the reflector 3. In other words, the reflector 3 and the two threaded shafts 61 are formed in one piece.

The second fixing means comprise a screw 62 configured to be screwed into the corresponding threaded shaft 61. Since there are two threaded shafts 61, there are also two screws 62. In turn, the printed circuit board 1 comprises two primary through holes 11, one for each screw 62, so that each screw 62 crosses the printed circuit board 1 through these primary through holes 11 to reach at the threaded shafts 61.

The cooperation between the first fixing means and the second fixing means, here the screwing of the threaded shaft 62 and the screws 61, provides pressure on the printed circuit board 1 so that the electric pads of the printed circuit board 1 are pressed against the electric connector terminals 51. Furthermore, the printed circuit board 1 cannot move away from the reflector 3 once the screws 62 are screwed into the threaded shaft 61.

In the embodiment of figures 1 and 2, the luminous device 100 further comprises positioning means 4. The latter comprises a positioning pin 32 integrated in the reflector 3 and secondary through hole 12 made in the printed circuit board 1. When the printed circuit board 1 is placed on the reflector 3, the positioning pin 32 engages in the through hole 12 in order to correctly position the printed circuit board 1 with the reflector 3 so that the primary through holes 11 are centred on the central axis of the threaded shaft 61. This helps to perform the screwing without any difficulty. Furthermore, the positioning means 4 as described allow the LED 2 to be correctly positioned with respect to the reflector 3 in order to ensure a good orientation of the two elements with respect to each other. In addition, the positioning means 4 make it possible to avoid the movement of the printed circuit board 1 in its own plane during the screwing of the screws 62 on the threaded shaft 61. In this respect, the LED 2 is always kept in a good position and the light performance is guaranteed.

In the example given, there are two identical positioning means 4, one on the right and one on the left side of the luminous device 100.

Figure 3 shows only the printed circuit board 1 and the electric connector 5 in a perspective view from below. As shown in this figure, the electric connector 5 comprises electric connector terminals 51 that are intended to be in contact with the electric pads 15 of the printed circuit board 1. In the given example, the terminals 51 are spring blades that are deformed when pressed against the electric pads 15. Through this contact, electric pads 15 receive electric supply from the electric connector terminals 51, which in turn are electrically connected to the main power supply through a wire harness 52.

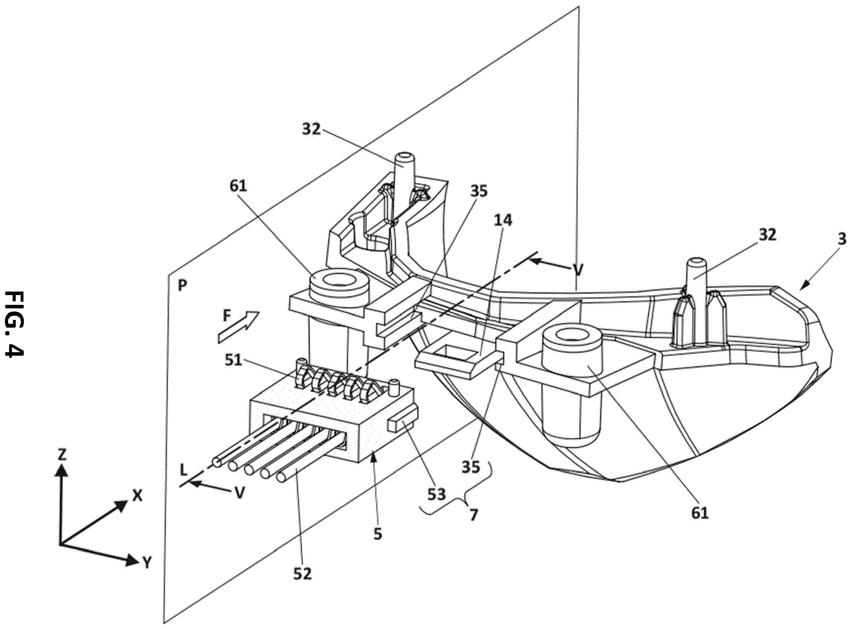

In the given example and as shown in figures 4 to 6, the connection between the electric connector 5 and the reflector 3 is ensured by third fixing means 35 and fourth fixing means 53. Here the third and fourth fixing means form a second set 8 of fixing means.

Here the third fixing means comprise a pair of guiding grooves 35 arranged symmetrically with respect to a vertical plan P containing the longitudinal axis L of the electric connector 5. In this example, the pair of guiding grooves 35 is integrated in the reflector 3. The fourth fixing means comprise a pair of guiding ribs 53 on both sides of the electric connector 5 in such a manner that each guiding rib 53 is facing a corresponding guiding groove 35. In other words, the guiding ribs 53 are also arranged symmetrically with respect to the vertical plan P mentioned above.

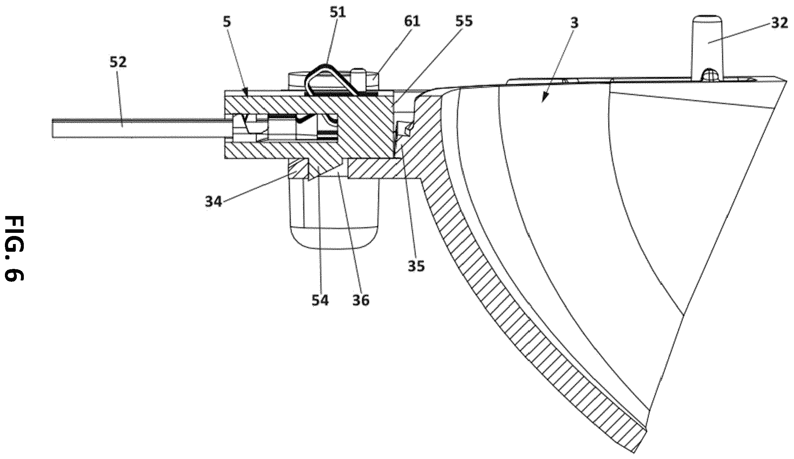

The third and fourth fixing means 35, 53 thus configured allow the connector to slide in the X direction from the rear to the front as indicated by the arrow F shown in figure 3. The stroke of the electric connector 5 stops when a front end 55 of the electric connector comes into contact with an edge 35 of the reflector 3. In this state, the electric connector 5 is fully engaged with the reflector 3, as shown in figure 6.

The cooperation between the guiding grooves 35 and the guiding ribs 53 prevents the translation of the electric connector along the Y and Z directions and prevents the rotation of the electric connector about the three directions X, Y and Z.

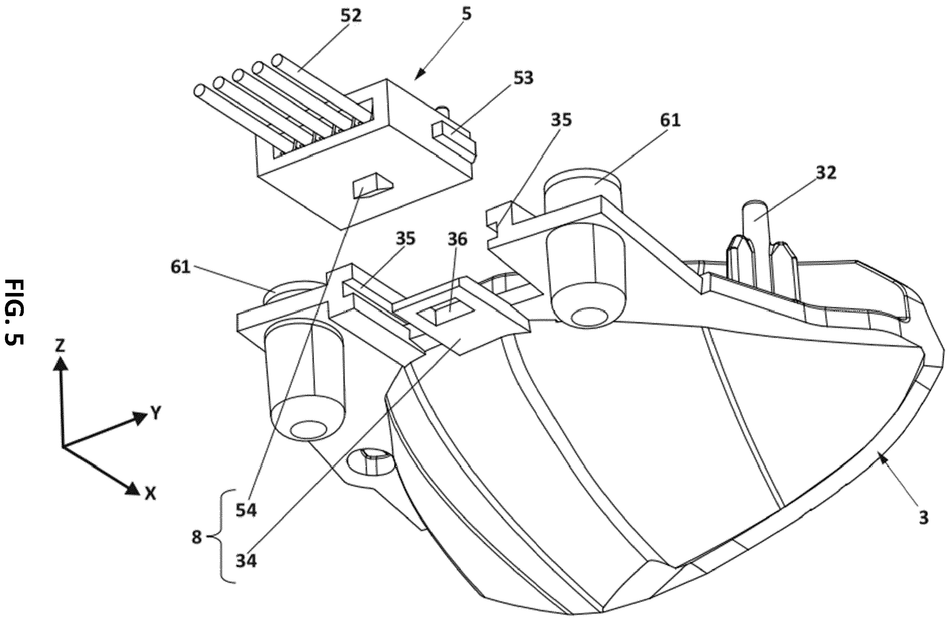

In order to prevent the disengagement of the electric connector 5 from the reflector 3 by a rearward translation along the X direction, the automotive luminous device 100 further comprises additional fastening means 8 as shown in figure 5. In this embodiment, the additional fastening means 8 are composed of elementary fixing means 34 and 54 that are a snap-fit protrusion 54 incorporated in the electric connector 5 and an elastic tab 34 belonging to the collector 3.

During the movement of the electric connector to the fully engaged position, the snap-fit protrusion 54 comes into contact with the elastic tab 34 and deforms the elastic tab 34 until the snap-fit protrusion 54 fits into an aperture 36 formed in the elastic tab 34. The snap-fit protrusion 54 and the elastic tab 34 as well as its aperture 36 are configured such that the moment when the protrusion 54 fits into the aperture 36 is also the moment when the front end 55 of the electric connector 5 abuts against the edge 35 of the reflector 3. In this way, the translation along the X direction rearward of the electric connector 5 is suppressed. The electric connector 5 is thus held in a fixed position with the reflector 3.

As can be seen, the elements allowing the electric connector 5 to be fixed to the reflector 3, such as the third fixing elements 35, the fourth fixing elements 53 and the additional fastening means 8, are different from those used to connect the electric connector 5 to the printed circuit board 1, i.e. the first fixing means 61 and the second fixing means 62. In other words, each pair of elements (electric connector 5 and reflector 3, electric connector 5 and printed circuit board 1) is fixed to each other by its own fixing means. In this respect, the automotive lighting device is guaranteed in terms of robustness.

## Claims

1. Automotive luminous device (10) comprising
a main support (3) comprising first fixing means (61);
an electric connector (5) attached to the main support (3), the electric connector comprising electric connector terminals (51);
a substrate (1) comprising substrate pads (15) configured to cooperate with the electric connector terminals (51), and further comprising an electronic component (2) electrically connected to at least one of the substrate pads (15);
**characterized in that** the luminous device further comprises second fixing means (62) configured to cooperate with the first fixing means (61) to keep the substrate (1) in a connecting position where the substrate pads (15) are in contact with the electric connector terminals (51).

2. Automotive luminous device (10) according to claim 1, wherein the second fixing means (62) are integrated in the substrate (1).

3. Automotive luminous device (10) according to any of the preceding claims, wherein the first fixing means and the second fixing means are configured to form a snap-fit joint.

4. Automotive luminous device (10) according to claim 1, wherein the substrate (1) is configured to receive the second fixing means (62).

5. Automotive luminous device (10) according to claim 4, wherein
the second fixing means comprises a screw (62);
the first fixing means comprises a threaded element (61) for the screw (62),
the substrate (1) has a through hole (11) configured to be crossed by the screw (62) so that the screw (62) is engaged in the threaded element (61) after passing through the through hole (11).

6. Automotive luminous device (10) according to any of the preceding claims, wherein the substrate is a rigid plane substrate (1).

7. Automotive luminous device (10) according to any of the preceding claims, wherein the main support (3) comprises third fixing means (35) and the electric connector (5) comprises fourth fixing means (53) configured to cooperate with the third fixing means (35) to attach the electric connector to the main support (3).

8. Automotive luminous device (10) according to claim 7, wherein the third fixing means comprises a guiding groove (35) and the fourth fixing means comprises a guiding rib (53) configured to engage in the guiding groove (35) along an inserting direction.

9. Automotive luminous device (10) according to claim 8, wherein the main support (3) and the electric connector (5) comprises additional fastening means, configured to retain the electric connector with respect to the main support in the inserting direction.

10. Automotive luminous device (10) according to claim 9, wherein the additional fastening means comprise an elastic tab (34) with an aperture (36) and a snap-fit protrusion (54) intended to engage in the aperture (36) of the elastic tab (34).

11. Automotive luminous device (10) according to any of the preceding claims, wherein the electronic component is a solid-state light source (2).

12. Automotive luminous device (10) according to any of the preceding claims, wherein the main support (3) is a housing, an optical element, or a bezel.

13. Automotive luminous device (10) according to any of claims 1 to 10, wherein the electronic component is a driver element.

14. Automotive luminous device (10) according to claim 12, further comprising a solid-state light source and an optical element arranged to receive the light emitted by the solid-state light source and project the light in a projection direction.

15. Automotive luminous device (10) according to any of the preceding claims, further comprising positioning means for positioning the substrate (1) with respect to the main support (3), wherein the positioning means comprise:
- first guide elements (32) integrated in the main support or in the electric connector (5); and
- second guide elements (12) integrated in the substrate (1) and configured to cooperate with the first guide elements (32) to limit the movement of the substrate (1) with respect to the main support (3) in at least one direction.
